(19) Europäisches Patentamt

European Patent Office

Office européen des brevets

(11) **EP 0 908 735 B1**

(12) **EUROPÄISCHE PATENTSCHRIFT**

(45) Veröffentlichungstag und Bekanntmachung des Hinweises auf die Patenterteilung:
**16.02.2005 Patentblatt 2005/07**

(51) Int Cl.⁷: $G01R\ 23/02$, G01R 23/16

(21) Anmeldenummer: **98118893.1**

(22) Anmeldetag: **06.10.1998**

(54) **Verfahren zur Bestimmung der Frequenz eines Signals**

Method for determining the frequency of a signal

Procédé pour déterminer la fréquence d'un signal

(84) Benannte Vertragsstaaten:
**AT CH DE FR GB LI**

(30) Priorität: **10.10.1997 DE 19744691**

(43) Veröffentlichungstag der Anmeldung:
**14.04.1999 Patentblatt 1999/15**

(73) Patentinhaber: **EADS Deutschland GmbH**
**81663 München (DE)**

(72) Erfinder:
 • **Hermann, Franz**
  **89614 Öpfingen (DE)**
 • **Schuster, Manfred, Dr.**
  **89257 Illertissen (DE)**

(74) Vertreter: **Meel, Thomas et al**
**Patentassessor,**
**c/o Dornier GmbH**
**L H G**
**88039 Friedrichshafen (DE)**

(56) Entgegenhaltungen:
 **US-A- 5 291 081    US-A- 5 499 391**

 • **DATABASE WPI Section EI, Week 198232 Derwent Publications Ltd., London, GB; Class S01, AN 1982-K6847E XP002171891 -& SU 873 145 A (STENYUKOV N S), 15. Oktober 1981 (1981-10-15)**

**Beschreibung**

Die Erfindung geht aus von eine Verfahren zur Bestimmung der Frequenz eines Signals nach dem Oberbegriff des Patentanspruchs 1.

In vielen Anwendungsfällen, insbesondere in der Meßtechnik sowie in der Elektrotechnik, ist es erforderlich, bei einem im Zeitbereich vorliegenden digitalisierten Signal mindestens eine Frequenz zu bestimmen, beispielsweise in einem modulierten Signal die Frequenzen der zugrunde liegenden Einzelsignale. Dazu wird beispielsweise das digitalisierte Signal in den Frequenzbereich transformiert, beispielsweise mittels einer an sich bekannten Fourier-Transformation oder der Fast-Fourier-Transformation (FFT). In dem Frequenzbereich entsteht dann ein dem Signal entsprechendes Linienspektrum, das in an sich bekannter Weise nach vorgebbaren Merkmalen ausgewertet werden kann. Beispielsweise kann bei einem modulierten Signal die Frequenz des Trägersignals ermittelt werden, beispielsweise durch eine Ermittlung der Lage von mindestens einer Spektrallinie auf der Frequenzachse und/oder durch Ausmessen von (Frequenz-)Abständen von vorgebbaren Spektrallinien. Die mit derartigen Verfahren erreichbaren Genauigkeiten sind in einigen Anwendungsfällen nicht ausreichend.

In der US 5,291,081 ist ein Verfahren zur Bestimmung der Frequenz eines Signals offenbart, bei dem mittels fortlaufender Fourier-Transformation eine Folge von Transformationsintvervallen entsteht. In jedem Transformationsintervall wird die maximale Frequenzkomponente bestimmt. In der nächsten Stufe der Verarbeitung wird unter den so gewonnen maximalen Frequenzkomponenten der einzelnen Transformationsintervalle das Maximum über alle Transformationsintervalle bestimmt. Die gesuchte Frequenz ergibt sich durch Interpolation des derart bestimmten Maximalwerts einer Frequenzkomponente mit dem Wert seiner benachbarten Komponente.

In der **SU-A-873145** ist ein gattungsgemäßes Verfahren beschrieben, bei dem eine Fourier-Transformation derart wiederholt wird, dass eine lückenlose Folge von Transformationsintervallen entsteht. In den Transformationsintervallen werden jeweils komplexe Ergebnisvektoren ermittelt, wobei neben der Amplitudenkomponente auch deren Phasenkomponente ermittelt wird. Zur Ermittlung der Frequenz des Signals werden Phasendifferenzen zwischen zwei, derselben Frequenzlinie zugehörigen Ergebnisvektoren aus unterschiedlichen Transformationsintervallen gebildet.

Der Erfindung liegt daher die Aufgabe zugrunde, ein gattungsgemäßes Verfahren dahingehend zu verbessern, daß eine vorgebbare genaue und schnelle Frequenzmessung möglich wird.

Diese Aufgabe wird gelöst durch die im kennzeichnenden Teil des Patentanspruchs 1 angegebenen Merkmale. Vorteilhafte Ausgestaltungen und/oder Weiterbildungen sind den weiteren Ansprüchen entnehmbar.

Ein erster Vorteil der Erfindung besteht darin, daß das erfindungsgemäße Verfahren weitgehend unabhängig ist von absichtlichen und/oder unabsichtlichen Störungen sowie Umweltbedingungen, beispielsweise einem weiteren überlagerten Signal, das nahezu identisch ist mit dem auszuwertenden Signal.

Ein zweiter Vorteil besteht darin, daß ein vorgebbar genaue Frequenzbestimmung auch bei gepulsten Signalen möglich ist.

Ein dritter Vorteil besteht darin, daß die Erfindung auch bei Hoch- oder Höchstfrequenz-Signalen anwendbar ist.

Ein vierter Vorteil besteht darin, daß eine hohe Alterungsbeständigkeit einer nach dem Verfahren betriebenen Anordnung erreichbar ist. Es entsteht vorteilhafterweise eine gute Reproduzierbarkeit der Meßergebnisse, da insbesondere das sogenannte Driften vermieden wird.

Weitere Vorteile ergeben sich aus der nachfolgenden Beschreibung.

Die Erfindung wird im folgenden anhand von Ausführungsbeispielen näher erläutert unter Bezugnahme auf schematisch dargestellte Figuren. Es zeigen

Fig.1 und Fig. 2      schematisch dargestellte Diagramme, die ausschließlich zur Erläuterung der Erfindung dienen, die selbst jedoch keine erfindungsgemäße Verfahren darstellen.

Fig. 3 -6      schematisch dargestellte Diagramme, die jeweils eine erfindungsgemäße Ausführung betreffen.

Bei der Erfindung wird ein im Zeitbereich vorliegendes analoges elektrisches Signal zunächst in an sich bekannter Weise digitalisiert mittels eines Analog/Digital-Wandlers, so daß sogenannte Abtastwerte entstehen. Bei Hoch- oder Höchstfrequenzsignalen ist es bedarfsweise zweckmäßig, diese zunächst in bekannter Weise mittels eines Mischvorganges in einen vorgebbaren niedrigeren Frequenzbereich umzusetzen, beispielsweise einen sogenannten Zwischenfrequenzbereich. Das in diesem ZF-Bereich vorliegende analoge Signal wird dann digitalisiert. Eine solche Umsetzung ist beispielsweise in der Radar-Technologie derzeit üblich. Eine vorgebbare zeitlich periodische Folge von Abtastwerten, beispielsweise jeweils maximal ungefähr 2000, wird anschließend durch eine an sich bekannte zeitlich lückenlose komplexe digitale Filterung, vorzugsweise eine an sich bekannte komplexe FFT (Fast-Fourier-Transformation), in den Frequenzbereich umgesetzt. Bei der FFT wird die zeitliche Länge (Zeitdauer) einer solche Folge von Abtastwerten auch FFT-Intervall genannt. In diesem entsteht ein dem analogen Signal entsprechendes komplexes Linienspektrum, das heißt, zu jeder (Frequenz-)Linie gehört ein (FFT-)Ergebnisvektor, der aus den Komponenten Amplituden- und Phasenwert besteht. Es ist nun naheliegend, in einem FFT-Intervall lediglich das sogenannte Amplitudenspektrum auszuwerten. In diesem kann beispielsweise zunächst diejenige (Frequenz-)Linie mit der größten Amplitude ausgewählt und anschließend deren Lage auf der Frequenzachse bestimmt werden. Außerdem ist es naheliegend, dieselbe Auswertung in einer vorgebbaren Anzahl von zeitlich aufeinanderfolgenden FFT-Intervallen vorzunehmen und anschließend ein Wichtung, beispielsweise eine Mittelwertbildung für die zu bestimmende Frequenz vorzunehmen.

Eine wesentlich genauere Bestimmung der Frequenz einer vorgebbaren Linie ist nun mittels einer Auswertung der Phasen-Komponenten der Ergebnisvektoren möglich. Dieses wird nachfolgend näher beschrieben.

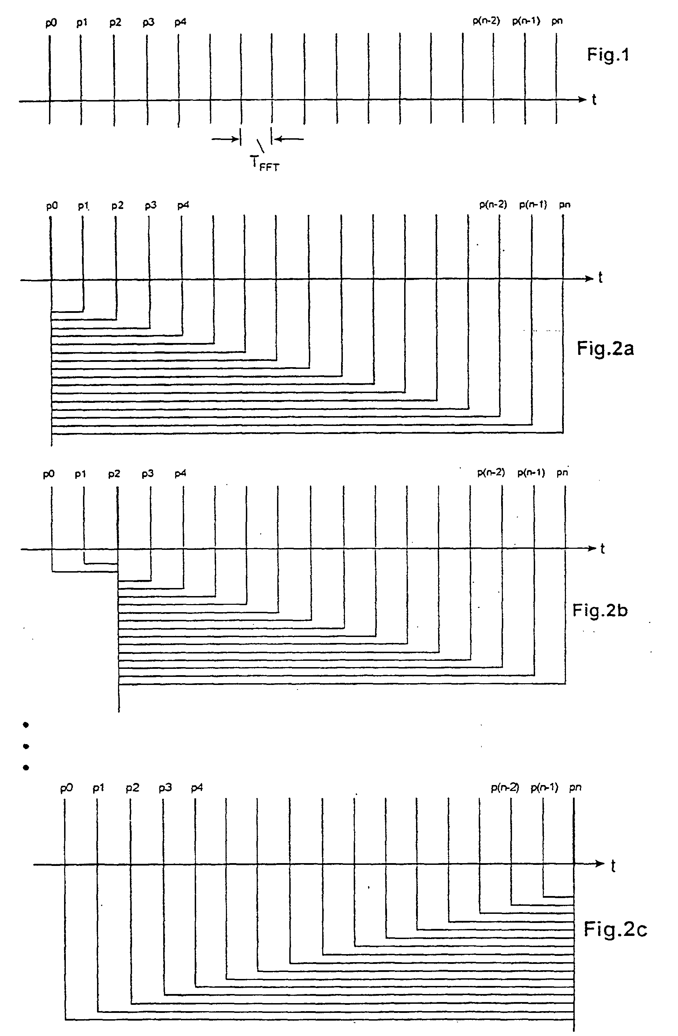

Fig.1 zeigt in einer schematischen Darstellung entlang der Zeitachse t eine vorgebbare Anzahl von Ergebnisvektoren p0 bis pn, wobei n eine positive ganze Zahl ist. Alle Ergebnisvektoren haben denselben zeitlichen Abstand $T_{FFT}$, wobei $T_{FFT}$ die zeitliche Länge des FFT-Intervalls bedeutet, und gehören zu derselben Frequenz, beispielsweise zu der Hauptlinie (größte Amplitude) innerhalb des FFT-Intervalls. Zu jedem Ergebnisvektor p0 bis pn gehört ein Phasenwert $\varphi_0$ bis $\varphi_n$, das heißt zu dem Ergebnisvektor p0 der Phasenwert $\varphi_0$, zu dem Ergebnisvektor p1 der Phasenwert $\varphi_1$ und so weiter. Da alle Ergebnisvektoren p1 bis pn zumindest geringfügig unterschiedlich sind, haben auch die zugehörigen Phasenwerte $\varphi_0$ bis $\varphi_n$ unterschiedliche Phasenwerte. Es werden nun Phasendifferenzen $\Delta\varphi_i$ gebildet gemäß der Formel

$$\Delta\varphi_i = \varphi_i - \varphi_{i-1} \tag{1}$$

mit 1 <= i <= n, dabei bedeutet <= kleiner gleich.

Damit ergibt sich die gesuchte genaue Frequenz F, die zu der ausgewählten Linie gehört, gemäß der Formel

$$F = f_{Linie} + \cdot \frac{1}{2\pi} \cdot \frac{\sum_{i=1}^{n} \Delta\varphi_i}{\sum_{i=1}^{n} \Delta t_i} \tag{2}$$

mit

$f_{Linie}$ =     Frequenz der ausgewählten Linie aus dem Amplitudenspektrum eines einzigen FFT-Intervalls,

$\Delta t_i$ =     zeitlicher Abstand zwischen den Ergebnisvektoren pi und p(i-1).

Bei dieser Summation der Phasendifferenzen $\Delta\varphi_i$ muß ein entstehender Übertrag (Vielfaches von 360 Grad) mitgerechnet werden.

Es ist ersichtlich, daß die Bestimmung der Frequenz F gemäß Formeln (1) und (2) um so genauer wird, je größer die Anzahl n der Phasendifferenzen $\Delta\varphi_i$ ist. Außerdem ist ersichtlich, daß eine Auswertung entsprechend Formeln (1) und (2) einen erheblichen Rechenaufwand (Auswerteaufwand) erfordert, insbesondere bei einer hohen Abtastrate (des A/D-Wandlers) und einem kurzen FFT-Intervall. In einem solchen Fall müßten elektronische Bauelemente und/oder Baugruppen mit einer relativ hohen Taktfrequenz, bezogen auf die Frequenz des analogen Signals, verwendet werden.

In den Fig.2a bis 2c sind Ergebnisvektoren p0 bis pn in Abhängigkeit von der Zeit t entsprechend Fig.1 dargestellt. Dabei wird dasselbe FFT-Intervall mit der zeitlichen Länge $T_{FFT}$ verwendet. Es werden nun zunächst Phasendifferenzen $\Delta\varphi_i$ entsprechend folgendem Schema gebildet, zunächst gemäß Fig.2a die Phasendifferenzen

$$\Delta\varphi_{01} = \varphi_0 - \varphi_1,$$

dann

$$\Delta\varphi_{02} = \varphi_0 - \varphi_2,$$

dann

$$\Delta\varphi_{03} = \varphi_0 - \varphi_3,$$

und so weiter bis

$$\Delta\varphi_{0n} = \varphi_0 - \varphi_n.$$

Dieses ist in Fig.2a durch Verbindungslinien unterhalb der Zeitachse t dargestellt. Die derart gebildeten Phasendifferenzen $\Delta\varphi_{01}$ bis $\Delta\varphi_{0n}$ sowie die zugehörigen Zeitdifferenzen $\Delta t_{01}$ bis $\Delta t_{0n}$ werden getrennt summiert und gespeichert. Anschließend werden entsprechend Fig.2b die Phasendifferenzen

$$\Delta\varphi_{12} = \varphi_1 - \varphi_2,$$

dann

$$\Delta\varphi_{13} = \varphi_1 - \varphi_3,$$

dann

$$\Delta\varphi_{14} = \varphi_1 - \varphi_4,$$

und so weiter bis

$$\Delta\varphi_{1n} = \varphi_1 - \varphi_n$$

gebildet.

Die derart gebildeten Phasendifferenzen $\Delta\varphi_{12}$ bis $\Delta\varphi_{1n}$ sowie die zugehörigen Zeitdifferenzen $\Delta t_{12}$ bis $\Delta t_{1n}$ werden ebenfalls getrennt summiert und ebenfalls gespeichert, vorzugsweise zu den bereits vorhandenen Phasen- und Zeitsummen, die entsprechend Fig.2a ermittelt wurden. Dieses Verfahren wird fortgesetzt, bis letztendlich entsprechend Fig.2c die Phasendifferenzen

$$\Delta\varphi_{n(n-1)} = \varphi_n - \varphi_{n-1},$$

dann

$$\Delta\varphi_{n(n-2)} = \varphi_n - \varphi_{n-2},$$

dann

$$\Delta\varphi_{n(n-3)} = \varphi_n - \varphi_{n-3},$$

und so weiter bis

$$\Delta\varphi_{n1} = \varphi_n - \varphi_1$$

gebildet werden. Die derart gebildeten Phasendifferenzen $\Delta\varphi_{n(n-1)}$ bis $\Delta\varphi_{n1}$ sowie die zugehörigen Zeitdifferenzen $\Delta t_{n(n-1)}$ bis $\Delta t_{n1}$ werden ebenfalls getrennt summiert und ebenfalls gespeichert, vorzugsweise zu den bereits vorhandenen Phasen- und Zeitsummen.

Anschließend wird die Frequenz F ermittelt aus einer Auswertung entsprechend Formel (2).

Eine vorstehend anhand der Fig.2a bis 2c beschriebene Auswertung ist vorteilhafterweise technisch einfach und innerhalb kurzer Zeit durchführbar mittels mindestens einem sogenannten Schieberegister, das eine Länge n besitzt, das heißt, es können zeitlich nacheinander (seriell) zunächst die zu den Ergebnisvektoren p0 bis pn gehörenden Phasenwerte $\varphi_1$ bis $\varphi_n$ eingelesen werden und anschließend, mittels eines parallelen Auslesevorganges die Phasendifferenzen $\Delta\varphi_{01}$ bis $\Delta\varphi_{n1}$ gebildet und in der beschriebenen Weise weiterverarbeitet werden.

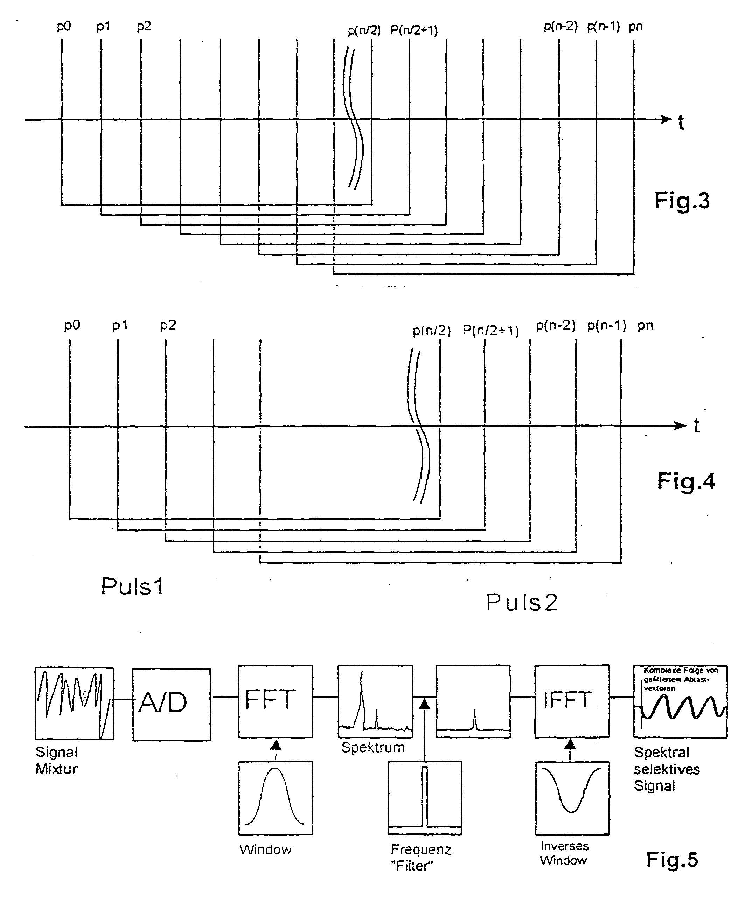

Das erfindungsgemäße Auswerteverfahren anhand der Fig.3 unterscheidet sich von demjenigen der Fig.2a bis 2c dadurch, daß die Phasendifferenzen $\Delta\varphi_i$ entsprechend folgendem Schema gebildet werden

$$\Delta\varphi_{0(n/2)} = \varphi_0 - \varphi_{n/2},$$

dann

$$\Delta\varphi_{1(n/2+1)} = \varphi_1 - \varphi_{n/2+1},$$

dann

$$\Delta\varphi_{2(n/2+2)} = \varphi_2 - \varphi_{n/2+2},$$

und so weiter bis

$$\Delta\varphi_{(n/2-1)n} = \varphi_{n/2-1} - \varphi_n ,$$

das heißt, die Phasendifferenzen werden immer zwischen den Phasenwerte $\varphi_i$ und $\varphi_{i+n/2}$, mit $0 <= i <= n/2-1$, gebildet.

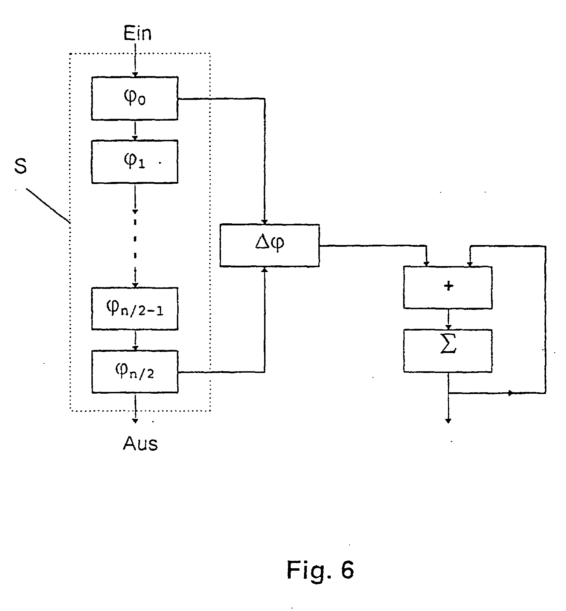

Die Frequenz F wird anschließend ermittelt wie anhand der Fig.2a bis 2c beschrieben. Dieses Verfahren entsprechend Fig.3 hat gegenüber demjenigen entsprechend Fig.2a bis 2c den Vorteil, daß lediglich ein Schieberegister S (Fig.6) mit einem Eingang Ein und einem Ausgang Aus sowie der Länge n/2 benötigt wird. Aus diesem müssen dann immer lediglich der erste und der letzte Phasenwert, $\varphi_0$ und $\varphi_{n/2}$ in Fig.6, ausgelesen werden, den diese haben den Abstand n/2. Zwischen diesen ausgelesenen Phasenwerten werden dann die Phasendifferenzen $\Delta\varphi$ gebildet und in der beschriebenen Weise ausgewertet, also summiert, wobei der Übertrag (360 Grad) berücksichtigt wird ($\Sigma$, + in Fig.6). Es werden also lediglich Phasendifferenzen von der halben Meßperiode (ganze Meßdauer = $n \cdot T_{FFT}$) ermittelt und summiert. Diese Summe muß dann dividiert werden durch die Anzahl der gemessenen Phasendifferenzen (n/2) multipliziert mit der halben Meßperiode ($n/2 \cdot T_{FFT}$):

$$F = f_{Linie} + \cdot \frac{1}{2\pi} \cdot \frac{\sum_{i=0}^{(n/2)-1} \Delta\varphi_i}{n/2 \cdot n/2 \cdot T_{FTT}}$$

$$F = f_{Linie} + \frac{1}{2\pi} \cdot \frac{1}{T_{FFT}} \cdot \frac{4}{n^2} \sum_{i=0}^{(n/2)-1} \Delta\varphi_i \ .$$

Das anhand der Fig.3 beschriebene erfindungsgemäße Verfahren ist insbesondere dann vorteilhaft anwendbar, wenn die Frequenz F bei einem gepulsten hochfrequenten kohärenten analogen Signal ermittelt werden soll. Ein solches analoges Signal, das aus einer zeitlichen Folge von sogenannten Bursts besteht, entsteht beispielsweise dadurch, daß ein monofrequentes hochfrequentes kohärentes Trägersignal mittels eines Rechtecksignales, mit nahezu beliebigem Tastverhältnis, vollständig moduliert wird. Ein solches analoges HF-Signal wird beispielsweise als Sendesignal bei einem Pulsradar verwendet.

Soll nun beispielsweise bei einem solchen gepulsten analogen Signal bei mindestens einem Puls die Frequenz des Trägersignals ermittelt werden, so ist es zweckmäßig, eine Auswertung entsprechend Fig.3 vorzunehmen. Dabei werden für ein bedarfsweise in einen vorgebbaren ZF-Bereich herabgemischtes zugehöriges analoges Signal die Abtastrate (des A/D-Wandlers), die zeitliche Länge $T_{FFT}$ eines FFT-Intervalls, die Anzahl der darin enthaltenen Abtastwerte sowie die Anzahl n der FFT-Intervalle derart gewählt, daß die Formel n • $T_{FFT}$ <= Pulsdauer gilt. Diese zu wählenden Parameter sind abhängig von der Pulsdauer, der Frequenz des Trägersignals sowie der gewünschten Genauigkeit für die Frequenz F (Formel (2)). Es ist ersichtlich, daß unter diesen Bedingungen prinzipiell vorteilhafterweise ein einziger Puls ausreicht, um die Frequenz F des Trägersignals zu bestimmen.

Ist die Pulsdauer relativ kurz und soll die Frequenzbestimmung trotzdem mit einer vorgebbar hohen Genauigkeit erfolgen, so ist es vorteilhafterweise möglich, zur Bestimmung der Frequenz F eine Auswertung, die sich über mindestens zwei kohärente Pulse erstreckt, vorzunehmen. Dieses wird anhand der Fig.4 erläutert. Dabei haben die dort dargestellten Pulse Puls1, Puls2 eine gleiche Pulsdauer. Diese ist derart gewählt, daß die Formel n/2 • $T_{FFT}$ <= Pulsdauer gilt. Die zwischen den Pulsen vorhandene Pulspause kann nahezu beliebig lang sein. Die Bestimmung der Frequenz F erfolgt dann ebenfalls wie anhand Fig.3 beschrieben.

Fig.5 zeigt eine Weiterbildung der Erfindung, die für die Bestimmung der Frequenz F bei einem stark gestörten analogen Signal (Signal Mixtur) geeignet ist. Dabei werden die komplexen Ergebnisvektoren dadurch gebildet, dass ein schnell abgetastetes (A/D gewandeltes) reelles Signal zuerst durch einen komplexen FFT-Prozess FFT in die Frequenzebene transformiert, optional durch Verwendung einer Frequenzmaske (Frequenz Filter) gefiltert (alle nicht erwünschten Frequenzanteile werden mit 0 multipliziert) und anschließend durch die Verwendung einer der obigen FFT angepaßten inversen komplexen FFT wieder in den Zeitbereich zurücktransformiert wird. Es entsteht ein digitales spektral selektives Signal, das aus einer Folge von gefilterten komplexen Ergebnisvektoren (Abtastvektoren) besteht.

Die so bearbeitete Folge der Abtastwerte enthält nun eine Folge von komplexen Vektoren, welche ein (optional) frequenzgefiltertes Abbild des analogen HF-Signals darstellen. Diese Folge der Abtastwerte kann entsprechend einem der anhand der Fig.1 bis Fig.4 beschriebenem Verfahren weiterverarbeitet werden, vorzugsweise entsprechend einem Verfahren entsprechend Fig.3.

Dieses Verfahren hat vor allem dann Vorteile, wenn Pulse oder RF Eingangssignale "angeschnitten" oder relativ kurz sind, das heißt lediglich über eine zeitliche Länge von maximal zwei FFT-Intervalle gehen.

Mit dem beschriebenen Verfahren ist beispielsweise für ein gepulstes HF-Signal (beispielsweise ein gepulstes Trägersignal mit Trägerfrequenz von 0,2 GHz), das mit einer Abtastfrequenz von ungefähr 1 GHz abgetastet wird, eine Genauigkeit (rms) entsprechend der folgenden Tabelle erreichbar. Dabei wird bei dem analogen Eingangssignal ein Signal zu Rauschabstand von 0 dB zugrunde gelegt und es wird eine 64-Punkt FFT verwendet, das heißt, ein FFT-Intervall enthält 64 Abtastwerte.

| Verfahren entsprechend | ein Puls mit 1µs Pulsdauer | 2 Pulse mit je 1µs Pulsdauer und 100 µs Pulsabstand | ein Puls mit 100 µs Pulsdauer |
|---|---|---|---|
| Fig.1 | 100 kHz | 100 kHz | 1 kHz |
| Fig.3 | 10 kHz | 60 Hz (Fig.4) | 4 Hz |
| Fig.5 | 3 kHz | 10 Hz | 1 Hz |

Es ist ersichtlich, daß die Erfindung in einem weiten Bereich der Elektrotechnik und/oder Meßtechnik zur Bestimmung einer Frequenz einsetzbar ist, beispielsweise bei der Bestimmung des Einfallswinkels einer elektromagnetischen Welle, wobei die zu der Welle gehörende Frequenz bekannt sein muß. Ein solches Verfahren ist in der am selben Tag eingereichten deutschen Patentanmeldung mit dem amtlichen deutschen Aktenzeichen DE 19744692 beschrieben.

**Patentansprüche**

1. Verfahren zur Bestimmung der Frequenz eines Signals, wobei

- mittels eines Analog/Digitalwandlers ein im Zeitbereich vorliegendes elektrisches Signal in ein entsprechendes digitalisiertes Signal umgewandelt wird,

- das digitalisierte Signal mittels einer digitalen Filterung, vorzugsweise einer Fourier-Transformation, in den Frequenzbereich umgesetzt wird, so daß ein dem Signal entsprechendes Linienspektrum entsteht und

- in dem Linienspektrum aus mindestens einer vorgebbaren zu dem Signal gehörenden Spektrallinie eine Frequenz des Signals ermittelt wird,

- zumindest innerhalb eines vorgebbaren Meßzeitraumes die digitale Filterung zeitlich periodisch wiederholt wird, so daß innerhalb des Meßzeitraumes eine zeitlich lückenlose Folge von Transformations-Intervallen (FFT-Intervallen) entsteht,

- die digitale Filterung derart ausgeführt wird, daß in jedem Transformations-Intervall (FFT-Intervall) mindestens ein komplexer Ergebnisvektor (p0 bis pn), der eine Amplituden- sowie eine Phasenkomponente ($\varphi$) besitzt, entsteht, **dadurch gekennzeichnet,**

- **daß** innerhalb des Meßzeitraumes nach einem vorgebbaren Schema paarweise Ergebnisvektoren (p0, p1), welche derselben vorgebbaren (Frequenz-)Linie entsprechen und welche zu unterschiedlichen vorgebbaren Transformations-Intervallen (FFT-Intervallen) gehören, ausgewählt werden, und zwar derart, dass zwischen den paarweise ausgewählten Ergebnisvektoren der zeitliche Abstand ($\Delta t_i$) konstant ist und dieser zeitliche Abstand ($\Delta t_i$) n/2 Transformations-Intervalle umfaßt, wobei n die Gesamtzahl der Transformations-Intervalle innerhalb des Meßzeitraums ist,

- **daß** für jedes Paar ausgewählter Ergebnisvektoren (p0, p1) eine zugehörige Phasendifferenz ($\Delta\varphi$) gebildet wird und

- **daß** aus den Phasendifferenzen ($\Delta\varphi$) die zu den ausgewählten Ergebnisvektoren gehörende Frequenz F ermittelt wird entsprechend der Formel

$$F = f_{Linie} + \frac{1}{2\pi}\frac{1}{T_{FFT}}\frac{4}{n^2}\sum_{i=0}^{(n/2)-1}\Delta\varphi_i$$

mit

$1/T_{FFT} =$     1/(Abtastintervall bei der Analog/Digital-Wandlung • Anzahl der Abtastwerte innerhalb des Transformations-Intervalls),

$f_{Linie} =$     Frequenz der ausgewählten Linie aus dem Amplitudenspektrum eines einzigen Transformations-Intervalls,

$T_{FFT} =$     zeitliche Länge des Transformations-Intervalls,

$\Delta t_i =$     zeitlicher Abstand zwischen den paarweise ausgewählten Ergebnisvektoren.

2. Verfahren zur Bestimmung der Frequenz eines Signals nach Anspruch 1, **dadurch gekennzeichnet, daß** als digitale Filterung eine zeitlich lückenlose komplexe Fast Fourier Transformation verwendet wird.

3. Verfahren zur Bestimmung der Frequenz eines Signals nach einem der vorhergehenden Ansprüche, **dadurch gekennzeichnet, daß** bei der Bestimmung der Frequenz eines gepulsten HF-Signales die zeitliche Länge des Meßzeitraumes zumindest einen Puls umfaßt.

4. Verfahren zur Bestimmung der Frequenz eines Signals nach einem der vorhergehenden Ansprüche, **dadurch gekennzeichnet, daß** bei der Bestimmung der Frequenz eines gepulsten HF-Signals die zeitliche Länge des Meßzeitraumes zumindest zwei Pulse umfaßt und daß die Anzahl der Transformations-Intervalle in jedem Puls zu n/2 gewählt wird, wobei n die Gesamtzahl der Transformations-Intervalle innerhalb des Meßzeitraumes angibt.

5. Verfahren zur Bestimmung der Frequenz eines Signals nach einem der vorhergehenden Ansprüche, **dadurch gekennzeichnet, daß** bei einem gestörten analogen Signal zunächst eine Frequenz-Filterung durchgeführt wird, bestehend aus

- einer Analog/Digital-Wandlung des Signals,

- einer anschließenden Fast-Fourier-Transformation,
- einer vorgebbaren digitalen Frequenz-Filterung und
- einer inversen Fast-Fourier-Transformation,

so daß ein Folge von gefilterten komplexen Ergebnisvektoren entsteht, aus welchen die Frequenz ermittelt wird.

**Claims**

1. Method for determination of the frequency of a signal, with

   - an electrical signal in the time domain being converted by means of an analogue/digital converter to a corresponding digitized signal,
   - the digitalized signal being converted by means of digital filtering, preferably by means of a Fourier transformation, to the frequency domain, thus resulting in a line spectrum corresponding to the signal, and
   - a frequency of the signal being determined in the line spectrum from at least one spectral line which can be predetermined and is associated with the signal,
   - the digital filtering being repeated periodically in time at least within a measurement time period which can be predetermined, so that a sequence of transformation intervals (FFT intervals) without any gaps in time is produced within the measurement time period,
   - the digital filtering is carried out in such a way that at least one complex result vector (p0 to pn) which has an amplitude as well as a phase component ($\varphi$) is produced in each transformation interval (FFT interval), **characterized**
   - **in that** pairs of result vectors (p0, p1) which correspond to the same (frequency) line which can be predetermined and which belong to different transformation intervals (FFT intervals) which can be predetermined are selected within the measurement time period in accordance with a scheme which can be predetermined, to be precise in such a manner that the time interval ($\Delta t_i$) between the pairs of selected result vectors is constant, and this time interval ($\Delta t_i$) comprises n/2 transformation intervals, where n is the total number of transformation intervals within the measurement time period,
   - **in that** an associated phase difference ($\Delta\varphi$) is formed for each pair of selected result vectors (p0, p1), and
   - **in that** the frequency F associated with the selected result vectors is determined from the phase differences ($\Delta\varphi$) using the formula:

$$F = f_{Line} + \frac{1}{2\pi}\frac{1}{T_{FFT}}\frac{4}{n^2}\sum_{i=0}^{(n/2)-1}\Delta\varphi_i$$

   where

   | | |
   |---|---|
   | $1/T_{FFT}$ = | 1/(sampling interval for analogue/digital conversion $\times$ number of sample values within the transformation interval), |
   | $f_{Line}$ = | frequency of the selected line from the amplitude spectrum of a single transformation interval, |
   | $T_{FFT}$ = | time duration of the transformation interval, |
   | $\Delta t_i$ = | time interval between the pairs of selected result vectors. |

2. Method for determination of the frequency of a signal according to Claim 1, **characterized in that** a complex Fast Fourier Transformation without any gaps in time is used as the digital filtering.

3. Method for determination of the frequency of a signal according to one of the preceding claims, **characterized in that** the time duration of the measurement time period for determination of the frequency of a pulsed RF signal is at least one pulse.

4. Method for determination of the frequency of a signal according to one of the preceding claims, **characterized in that** the time duration of the measurement time period for determination of the frequency of a pulsed RF signal is at least two pulses, and **in that** the number of transformation intervals in each pulse is chosen to be n/2, where n indicates the total number of transformation intervals within the measurement time period.

5. Method for determination of the frequency of a signal according to one of the preceding claims, **characterized in that**, when an analogue signal is subject to interference, frequency filtering is carried out first of all, comprising

- analogue/digital conversion of the signal,
- subsequent Fast Fourier Transformation,
- digital frequency filtering which can be predetermined, and
- inverse Fast Fourier Transformation,

thus resulting in a sequence of filtered complex result vectors, from which the frequency is determined.

**Revendications**

1. Procédé de détermination de la fréquence d'un signal, dans lequel:

- un signal électrique appliqué dans le domaine temporel est converti en un signal numérique correspondant au moyen d'un convertisseur analogique/numérique,
- le signal numérisé est converti dans le domaine des fréquences au moyen d'un filtrage numérique, de préférence d'une transformation de Fourier, de manière à obtenir un spectre de lignes qui correspond au signal et
- une fréquence du signal est déterminée dans le spectre de lignes à partir d'au moins une ligne spectrale prédéterminable qui appartient au signal,
- au moins à l'intérieur d'un laps de temps prédéterminable de mesure, le filtrage numérique est répété périodiquement dans le temps de manière à obtenir au cours du laps de temps de mesure une succession temporelle continue d'intervalles de transformation (intervalles FFT),
- le filtrage numérique est exécuté de telle sorte que dans chaque intervalle de transformation (intervalle FFT), on obtienne au moins un vecteur complexe de résultat (p0 à pn) qui possède une composante d'amplitude ainsi qu'une composante de phase ($\varphi$),

**caractérisé en ce que** :

- pendant le laps de temps de mesure, des paires de vecteur de résultat (p0, p1) qui correspondent à la même ligne (de fréquence) prédéterminable et qui appartiennent à différents intervalles de transformation (intervalles FFT) prédéterminables sont sélectionnées selon un schéma prédéterminable de telle sorte qu'entre les vecteurs de résultat sélectionnés par paires, l'écart temporel ($\Delta t_i$) soit constant et que cet écart temporel ($\Delta t_i$) comprenne n/2 intervalles de transformation, n étant le nombre total d'intervalles de transformation à l'intérieur du laps de temps de mesure,
- **en ce qu'**une différence de phase ($\Delta\varphi$) associée à chaque paire de vecteurs de résultat (p0, p1) sélectionnée est formée et
- **en ce qu'**à partir des déphasages ($\Delta\varphi$), la fréquence F qui appartient aux vecteurs de résultat sélectionnés est déterminée par la formule:

$$F = f_{Linie} + \frac{1}{2\pi} \frac{1}{T_{FFT}} \frac{4}{n^2} \sum_{i=0}^{(n/2)-1} \Delta\varphi_i$$

dans laquelle
$1/T_{FFT}$ = 1/(intervalle d'échantillonnage de la conversion analogique/numérique x nombre des valeurs d'échantillonnage à l'intérieur de l'intervalle de transformation),
$f_{Linie}$ = fréquence de la ligne sélectionnée dans le spectre d'amplitude sur un seul intervalle de transformation,
$T_{FFT}$ = longueur temporelle de l'intervalle de transformation,
$\Delta t_i$ = écart temporel entre les vecteurs de résultat sélectionnés par paires.

2. Procédé de détermination de la fréquence d'un signal selon la revendication 1, **caractérisé en ce que** comme filtrage numérique, on utilise une transformation rapide de Fourier complexe et continue dans le temps.

3. Procédé de détermination de la fréquence d'un signal selon l'une des revendications précédentes, **caractérisé**

**en ce que** lors de la détermination de la fréquence d'un signal HF pulsé, la longueur temporelle du laps de temps de mesure comprend au moins une impulsion.

4. Procédé de détermination de la fréquence d'un signal selon l'une des revendications précédentes, **caractérisé en ce que** lors de la détermination de la fréquence d'un signal HF pulsé, la longueur temporelle du laps de temps de mesure comprend au moins deux impulsions et **en ce que** le nombre des intervalles de transformation dans chaque impulsion est sélectionné à la valeur n/2, n donnant le nombre total des intervalles de transformations à l'intérieur du laps de temps de mesure.

5. Procédé de détermination de la fréquence d'un signal selon l'une des revendications précédentes, **caractérisé en ce que** dans le cas d'un signal analogique perturbé, on exécute au moins un filtrage en fréquence qui est constitué de:

- une conversion analogique/numérique du signal,
- ensuite une transformation rapide de Fourier,
- un filtrage numérique en fréquence prédéterminable et
- une transformée rapide de Fourier inverse,

de manière à obtenir une succession de vecteurs complexes de résultat filtrés à partir desquels on détermine la fréquence.

Fig.1

Fig.2a

Fig.2b

Fig.2c

p0   p1   p2                          p(n/2)  P(n/2+1)        p(n-2)  p(n-1)  pn

t

**Fig.3**

p0   p1   p2                          p(n/2)  P(n/2+1)        p(n-2)  p(n-1)  pn

t

**Fig.4**

Puls1

Puls2

Signal
Mixtur

A/D

FFT

Spektrum

IFFT

Komplexe Folge von
gefilterten Abtastvektoren

Spektral
selektives
Signal

Window

Frequenz
"Filter"

Inverses
Window

**Fig.5**

Fig. 6